(19) Europäisches Patentamt
European Patent Office
Office européen des brevets

(11) EP 1 847 837 A1

(12) **EUROPEAN PATENT APPLICATION**

(43) Date of publication:
**24.10.2007 Bulletin 2007/43**

(51) Int Cl.:
***G01R 23/16*** *(2006.01)*

(21) Application number: **06008339.1**

(22) Date of filing: **21.04.2006**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(71) Applicants:
• **Fondazione Torino Wireless**
  **10129 Torino (IT)**
• **Istituto Superiore Mario Boella**
  **10129 Torino (IT)**
• **POLITECNICO DI TORINO**
  **10129 Torino (IT)**

(72) Inventors:
• **Borio, Daniele**
  **10093 Collegno (TO) (IT)**
• **Camoriano, Laura**
  **10073 Cirie (TO) (IT)**
• **Lo Presti, Letizia**
  **10138 Torino (IT)**

(74) Representative: **Grünecker, Kinkeldey, Stockmair & Schwanhäusser Anwaltssozietät Maximilianstrasse 58 80538 München (DE)**

(54) **Method and apparatus for frequency estimation**

(57)    The present invention relates to a method for estimating the frequency $f_x$ of a periodic input signal $x_{in}$, comprising performing a Discrete Time Fourier Transform of N first time-discrete samples **x** of the input signal $x_{in}$, N being an integer $\geq 1$, to obtain a first transformed signal $X_1$; performing a Discrete Time Fourier Transform of N second time-discrete samples $\mathbf{x}_L$ of the input signal $x_{in}$ time-delayed by L samples with respect to the first time-discrete samples **x**, L being an integer $\geq 1$, to obtain a second transformed signal $X_2$; calculating the phase $\varphi_r$ of the ratio r of the second transformed signal $X_2(f)$ and the first transformed signal $X_1(f)$ at one single pre-selected frequency f; determining an estimate $\hat{f}_x$ for the frequency $f_x$ of the periodic input signal $x_{in}$ on the basis of the phase $\varphi_r$ of the ratio of the second transformed signal $X_2(f)$ and the first transformed signal $X_1(f)$ at the pre-selected frequency f; and generating an output signal on the basis of the estimate $\hat{f}_x$ for the frequency $f_x$.

FIG. 4

## Description

FIELD OF THE PRESENT INVENTION

The present invention relates to the art of signal tracking in communication and navigation systems and, in particular, the determination and tracking of the carrier frequency of a noisy modulated spreaded communication signal by means of a Frequency Lock Loop technique.

DESCRIPTION OF THE PRIOR ART

An important issue of signal processing, in general, is the accurate determination of the frequencies and phases of transmitted and received signals. The correct estimation of parameters of signals, as the frequency and phase, e.g., of single- or multiple-frequency tones from a finite time-discrete sample may, e.g., be necessary in the context of the identification of sinusoidal components of an audio signal, synchronization in telecommunication systems or the frequency tracking in power networks.

In many feedback control systems a generated signal has to be maintained in a fixed phase relationship and/or at an accurately determined frequency as, e.g., in frequency synthesizers for digitally tuned radio receivers, in lock-in amplifiers or dual tone multifrequency dialing decoders.

In the field of navigation/localization systems Global Navigation Satellite Systems (GNNS), as the Global Positioning System (GPS) and the European Galileo, are of growing importance. A GPS receiver, e.g., must be able to track the spread-spectrum signals, i.e. phase-modulated signals using bi-phase shift keying (BPSK) that it receives from GPS satellites with high accuracy. During the acquisition phase the carrier frequency and the phase angle of the coarse/acquisition (C/A code), for civil purposes, has to be determined. Accurate tracking of the carrier frequency and the Doppler shift caused by the relative velocity of the satellite with respect to the receiver are mandatory for an accurate determination of the position and velocity of the receiver. The Doppler shift is usually determined from the phase of the carrier signal. The maximum Doppler frequency for the L1 GPS signal having a frequency of 1575.42 MHz is about 5 kHz (for terrestrial applications).

When the carrier frequency changes, the receiver may loss track of the satellite signal. Whereas ideally the carrier frequency is known, due to noise and the satellite motion the actual carrier frequency is slightly different from the set value. This difference can be modeled as a time-varying phase.

In addition to Doppler shift, noise in form of white Gaussian noise introduces random perturbations in the phase and amplitude of the carrier and, thus, the prediction of the carrier phase is, in principle, uncertain.

Standard receivers track the C/A code phase by a Delay Locked Loop (DLL) and the carrier phase by a Phase Locked Loop (PLL). An apparatus employing both loops, called a signal tracking loop, is disclosed in US 5 222 843. Both loops represent feedback loops that align replica signals in the receiver with the actual received signal.

Typically, a PLL, usually in form of a Costas loop, consists of a numerically controlled oscillator, a carrier loop filter and a discriminator. The output of the discriminator is used to control the oscillator tuning the oscillation frequency so that the loop can continuously demodulate the received satellite signal. On the basis of the despreaded C/A code the signal output by the oscillator usually has both (inphase) I and (quadrature) Q channels. After correlating with the input signal the signal from each channel is lowpass filtered.

The above described conventional acquisition process includes, however, a high complexity and also demands for relatively powerful computer resources. Robustness of the conventional method might also be improved. Thus, it is the problem underlying the present invention to provide a more reliable and fast method for estimating the frequency of a received signal and a receiver employing such a method.

SUMMARY OF THE PRESENT INVENTION

The above-mentioned problem is solved by a method according to claim 1. The inventive method for estimating the frequency $f_x$ of a periodic input signal $x_{in}$, comprises

performing a Discrete Time Fourier Transform of N first time-discrete samples x of the input signal $x_{in}$, N being an integer $\geq 1$, to obtain a first transformed signal $X_1$;

performing a Discrete Time Fourier Transform of N second time-discrete samples $\mathbf{x}_L$ of the input signal $x_{in}$ time-delayed by L samples with respect to the first time-discrete samples $\mathbf{x}$, L being an integer $\geq 1$, to obtain a second transformed signal $X_2$;

calculating the phase $\varphi_r$ of the ratio r of the second transformed signal $X_2(f)$ and the first transformed signal $X_1(f)$ at one single pre-selected frequency f;

determining an estimate $\hat{f}_x$ for the frequency $f_x$ of the periodic input signal $x_{in}$ on the basis of the phase $\varphi_r$ of the ratio of the second transformed signal $X_2(f)$ and the first transformed signal $X_1(f)$ at the pre-selected frequency f; and

generating an output signal on the basis of the estimate $\hat{f}_x$ for the frequency $f_x$.

For fast performance, the estimate $\hat{f}_x$ for the frequency $f_x$ of the periodic input signal $x_{in}$ is iteratively calculated and the output signal is generated on the basis of the iteratively calculated values for $\hat{f}_x$. The output signal may be the estimated frequency itself to be used, e.g., in a signal/data acquisition and tracking systems.

With the discrete time index n the digital input signal, which may be a sinusoidal signal, can be written as proportional to $\cos(2\pi f_x n + \varphi)$, where $\varphi$ is the phase of the signal. The N first time-discrete samples of the input signal $x_{in}$ define a vector $\mathbf{x} = (x_{in}(0), x_{in}(1), .., x_{in}(N-1))$. Time-delaying of $\mathbf{x}$ by L (L being an integer $\geq 1$; in particular, L may be chosen to be equal or less than N results in further N time-discrete samples $\mathbf{x}_L$ ($x_{in}(L), x_{in}(L+1), .., x_{in}(L+N-1)$). At a frequency f the Discrete Time Fourier Transform (DTFT) can be evaluated, respectively, by

$$X_1(f) = \sum_{n=0}^{N-1} x_{in}(n)\exp(-i2\pi f n) \quad ; \quad X_2(f) = \sum_{n=0}^{N-1} x_{in}(n+L)\exp(-i2\pi f n).$$

According to the disclosed method two DTFTs are carried out over overlapping data segments. The complex ratio $r = X_2(f) / X_1(f)$, where $X_1$ and $X_2$ are taken at the same single frequency, can be expressed by means of an amplitude $m_r$ and a phase $\varphi_r$: $r = m_r \exp(i \varphi_r (f))$. The phase $\varphi_r$ not only includes information on the frequency f, but $g(f_x, f_x) := \varphi_r / 2\pi L$ actually represents a fixed point mapping for $f = f_x$ and, thus, the frequency $f_x$ to be determined from the input signal $x_{in}$ can, in principle, be estimated based on the phase $\varphi_r$.

As discussed in more detail in the detailed description of examples of the present inventive method below, by this example of the inventive method the same fixed point mapping can be incorporated whether or not the desired frequency $f_x$ of the input signal can actually be written as the ratio of some integer and the length N of the sample vectors $\mathbf{x}$ and $\mathbf{x}_L$.

Since the calculation of the ratio $X_2(f) / X_1(f)$ and the phase $\varphi_r$ can easily be performed with relatively low-performance computer facilities the present invention provides a method for the estimation of the frequency of an input signal that is less computer time and memory consuming than known in the art. In particular, the fixed point mapping allows for an iterative solution approach $\hat{f}_{x,i+1} = g(\hat{f}_{x,i}, f_x)$, i.e. a fixed point iteration, where the index i counts the iteration and the circumflex denotes the estimate for the real frequency $f_x$ of the input signal $x_{in}$ (see also discussion below). Iteration procedures can be performed very fast and robust algorithms are available that do not require for high-performance computer facilities. Thus, the desired frequency can be estimated very quickly. The output signal can, e.g., be identical to the solution of the fixed point mapping, in particular, to the final calculated iteration

$$\hat{f}_{x,F} = g(\hat{f}_{x,F-1}, f_x) = \frac{\varphi_{r,F}}{2\pi L} \, ,$$ if, e.g., F iterations have been performed. In receivers for Global Navigation Satellite Systems, e.g., the output signal can be used for carrier tracking.

The first estimate, i.e. the initial value, of the iteration $\hat{f}_{x,0}$ for estimating the frequency $f_x$ of the periodic input signal $x_{in}$ can be calculated by means of a Fast Fourier Transform (FFT). The frequency corresponding to the peak of the respective Fourier spectrum represents the initial value.

Some acquisition means as known in the art may receive and sample a transmitted signal to generate the input signal $x_{in}$. The acquisition means may provide a rough estimate $f_{acq}$ for the frequency $f_{in}$. The search for the peak in the Fourier transformed spectrum of a segment of the input signal may be performed in a limited frequency interval given by the size of the frequency bin provided by the acquisition means in order to avoid locking at a false peak. For a bin size of B the search can be limited to the interval $[f_{acq} - B, f_{acq} + B]$. Alternatively, a rough estimate can be given by the frequency that is a priori expected for the transmitted signal (as, e.g., 1575,42 MHz for the carrier frequency of the L1 signal of the GPS L band).

The use of the FFT allows for employing very fast and robust algorithms. In particular, according to the inventive method the iterative procedure allows for the evaluation of a long data segment without the need for an extensive FFT (see below). Several DTFTs are performed rather than one single long FFT, as it is necessary in the art, whereby the estimate for the desired frequency $f_x$ of the input signal $x_{in}$ is obtained unusually fast. To calculate the first estimate of the iteration $\hat{f}_{x,0}$ for the frequency $f_x$ of the periodic input signal $x_{in}$ by seeking for the peak of the Fast Fourier Transform in an interval ranging from one acquisition frequency bin below a rough estimate for the frequency $f_x$ of the periodic input signal $x_{in}$ to one acquisition frequency bin above the rough estimate for the frequency $f_x$ of the periodic input signal $x_{in}$ guarantees robustness of the proposed method.

If the noise that usually is present in the input signal $x_{in}$ is high, i.e. if the signal-to-noise ratio of the carrier is low, there could be a leap $\Delta$ in the estimated frequency, i.e. a finite difference between the estimated frequency and the actual one of the input signal, that depends on the number of samples L the second time-discrete samples $\mathbf{x}_L$ are time-delayed with respect to the first time-discrete samples $\mathbf{x}$ of the input signal $x_{in}$. Thus, a procedure may be included that determines which of the values $\hat{f}_x$ and $\hat{f}_x \pm \Delta$ is closest to, e.g., the acquisition frequency $f_{acq}$ mentioned above or some different rough estimate of the frequency $f_x$ of the input signal $x_{in}$.

Consequently, the inventive method may advantageously comprise the step of comparing the estimated frequency $\hat{f}_x$, $\hat{f}_x - \Delta$ and $\hat{f}_x + \Delta$, where $\Delta$ denotes some frequency leap, with a rough estimate for the frequency $f_x$ of the periodic input signal $x_{in}$ or with the first estimate of the iteration $\hat{f}_{x,0}$ for the frequency $f_x$ of the periodic input signal $x_{in}$ and the output signal can be generated on the basis of the comparison result. If, e.g., $\hat{f}_x + \Delta$ is closest to the rough estimate, this frequency will be chosen to be the estimate for the frequency $f_x$ and in this case the output signal will include information about this frequency.

If the iteration procedure for estimating the frequency $f_x$ includes i iterations, i ratios $r_i$ of respective second transformed signals $X_{L,i}(f)$ obtained by Discrete Time Fourier Transforms of N second time-discrete samples $\mathbf{x}_{L,i}$ delayed by L samples with respect to N first time-discrete samples $\mathbf{x}_i$ and respective first transformed signals $X_i(f)$ obtained by Discrete Time Fourier Transforms of N first time-discrete samples $\mathbf{x}_i$ for a frequency f that is equal to the estimation $\hat{f}_{x,i-1}$ of the frequency $f_x$ of the periodic input signal $x_{in}$ at the (i - 1) - th iteration are calculated. In form of a symbolic formula this calculation is expressed by $r_i = \{DTFT(\mathbf{x}_{L,i}) / DTFT (\mathbf{x}_i)| f= \hat{f}_{x,i-1}$. Moreover, i phase values $\varphi_{r,i}$ for the respective i ratios can be calculated and an i-th frequency estimation $\hat{f}_{x,i}$ can be calculated by $\hat{f}_{x,i} = \dfrac{\varphi_i}{2\pi L}$. The latter expression can subsequently be used for the i+1-th frequency estimation $\hat{f}_{x,i+1}$ to be calculated from $\hat{f}_{x,i+1} = g(\hat{f}_{x,i}, f_x)$. By employing this iteration procedure a Frequency Lock Loop can be established.

By this iteration procedure long data segments can be evaluated without the need for long FFTs. Several relatively short DTFTs that are evaluated at one single frequency, respectively, are employed rather than an exhaustive FFT. It should be noted that different noise samples are present at each step of the iteration procedure.

Due to the elimination of multiples of $2\pi$ the problem of phase ambiguities arises when employing the angle operator. This problem can be solved by adding a correction term to the estimated frequency, in particular, by adding a term round$(\hat{f}_{x,0} L)$ that takes into account the integer number of $2\pi$ - number of cycles.

In order to improve the estimate for the frequency $f_x$ of the input signal as well as the speed of iteration it might be helpful to filter the input signal $x_{in}$ by means of a noise reduction filtering means before performing the Discrete Time Fourier Transform of the N first time-discrete samples x.

Moreover, the input signal $x_{in}$ may be down-sampled before performing the Discrete Time Fourier Transform of the N first time-discrete samples x in order to reduce the complexity of the procedure of estimating the frequency $f_x$. The down-sampled signal may also be passed through a noise reduction filter. Furthermore, the down-sampled signal may be passed through a low-pass filter for anti-aliasing.

After completion of one of the above described examples of the iteration procedure a pre-selected number $M_L$ of iteratively calculated estimates $\hat{f}_{x,i}$ for the frequency $f_x$ of the periodic input signal $x_{in}$ may be sorted and the output value may be generated on the basis of the center value of the sorted estimates $\hat{f}_{x,i}$. This can be done by a median filter of length $M_L$. The finally estimated frequency, in this case, becomes the center value of the sorted estimates of the iteration procedure. The median filtering eliminates outliers of the estimate of the frequency $f_x$. Such outliers, however, are rare, if the signal-to-noise ratio of the carrier is sufficiently enhanced, e.g., by a noise reduction filtering means.

According to another example of the inventive method a mean value over a pre-selected time period of iteratively calculated estimates $\hat{f}_{x,i}$ for the frequency $f_x$ of the periodic input signal $x_{in}$ may be calculated. This may increase the accuracy of the finally estimated frequency, even if the convergence speed of the iteration procedure is low.

Moreover, different mean values may be calculated over different pre-selected time periods and the mean values of iteratively calculated estimates $\hat{f}_{x,i}$ may be filtered by a median filter wherein the filtering comprises sorting a pre-selected number of mean values taken over pre-selected time periods of iteratively calculated estimates $\hat{f}_{x,i}$ for the frequency $f_x$ of the periodic input signal $x_{in}$. This center value can be chosen as the finally determined estimate for the frequency of the input signal and the output value can be generated on the basis of the center value of the sorted mean values, in particular, the output signal may include information on the center value.

The disclosed method can be advantageously applied in the context of signals received from a transmitter that moves relatively to a receiver and that, consequently, show some Doppler shift. The inventive method may, e.g., be employed in a GPS receiver. Before processing the received signal it may be substantially corrected for the Doppler shift. Thus, the periodic input signal ($x_{in}$) may be obtained from a received signal exhibiting a Doppler shifted frequency by substantially correcting for the Doppler shift in the acquisition means that receives the sent signal as it is known in the art. If a major portion of the Doppler contribution is already eliminated from the input signal $x_{in}$, the effectiveness of the disclosed method increases.

Further, the method disclosed herein is particularly useful in the context of time-varying Doppler shifts. The application of several relatively short DTFTs instead of a long FFT allows for following time-varying Doppler shifts on very short time scales.

If the input signal $x_{in}$ is based on a signal generated by and received from a GPS satellite stripping of the C/A code and/or the P code before performing the Discrete Time Fourier Transform of the N first time-discrete samples x should be carried out. For example, the L1 signal sent by GPS satellites is binary phase shift keying (BPSK) modulated by the pseudo random noise (PRN) codes known as C/A code and the P code. In a GPS receiver employing examples of the above discussed examples the PRN codes are generated and used for the code stripping of the digital input signal representing the received GPS signal.

The present invention provides a data acquisition apparatus configured to perform the steps of the above-described methods. In particular, the inventive apparatus may comprise or consist of a receiver, in particular a Global Positioning System receiver, or a frequency synthesizer for digitally tuned radio receivers and transmitters or a decoder for remote control and telecommunications. The inventive method is of particular use in the above mentioned systems that require an accurate and fast frequency tracking.

The above-mentioned system may comprise signal receiving and tracking units, filtering means as, e.g., low-pass filters, median filters operating as discussed above, noise reduction filters, a CPU for calculating, e.g., the frequency estimate of the input signal $x_{in}$ by means of the FFT and DTFT operations and the phase determinations of the ratios of the time-delayed vectors and the non-delayed vectors of N samples of the input signal as discussed above, etc. The tracking unit can be configured to track the input signal on the basis of an output signal generated by some means on the basis of the estimated frequency of the input signal. The apparatus may also comprise a means configured to receive an analogous signal and to analogue-to-digital convert this signal in order to obtain a digital input signal $x_{in}$.

The inventive method can, in particular, advantageously be employed in a navigation system for a vehicle, as a car navigation system, allowing for acquisition and tracking of GPS data sent by GPS satellites. Since the computer resources of mobile GPS systems are limited, the efficiency of the inventive method can improve the reliability and overall performance of navigation systems installed in vehicles significantly. The same holds for handheld navigation systems.

The present invention further provides a computer program product, comprising one or more computer readable media having computer-executable instructions for performing the steps of the above-described methods.

Additional features and advantages of the present invention will be described with reference to the drawings. In the following description, reference is made to the accompanying figures that are meant to illustrate preferred embodiments of the invention. It is understood that such embodiments do not represent the full scope of the invention that is defined by the claims given below.

BRIEF DESCRIPTION OF THE DRAWINGS

Fig. 1 is a flowchart illustrating receiving and pre-processing of a periodic signal the frequency of which is to be estimated in accordance with the present inventive method.

Fig. 2 illustrates an example for the calculation of the first estimate for the frequency of a periodic input signal that is to be determined.

Fig. 3 illustrates the different data blocks used during the iteration procedure.

Fig. 4 illustrates basic steps of the disclosed method for estimating the frequency of a periodic input signal including an FFT of the input signal and DTFTs of sample vectors.

DETAILED DESCRIPTION

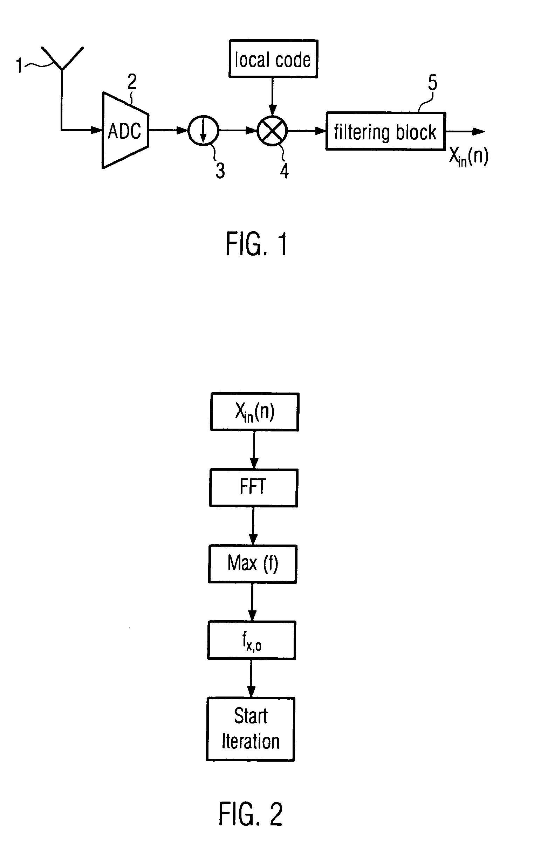

It is an object of the present invention to estimate the frequency $f_x$ of a periodic digital signal $x_{in}$ that ideally may be represented by $x_{in}(n) = A \cos(2\pi f_x n + \varphi)$, where $\varphi$ is the phase of the signal, n denotes the discrete time index and A is the amplitude. As shown in Fig.1 an analog signal transmitted by a transmitter (not shown) is received wirelessly 1 and it is subsequently analog-to-digital converted 2. The digitized signal is down-sampled 3 to reduce the complexity of the subsequent processing. The signal may be band pass filtered before the down-sampling to eliminate aliasing caused by the down-sampling.

By multiplication with a local code, e.g. the C/A code of GPS, the signal is subject to code stripping 4. The signal is then passed through a filtering block 5 to enhance the signal-to-noise ratio of the signal, in particular, the carrier. The filtered signal is the input signal $x_{in}(n)$ that is to be processed further. In the context of a GPS environment it is the aim to estimate the carrier frequency accurately.

In the following as an illustrative embodiment of the disclosed method using an iterative procedure for estimating the frequency $f_x$ of the input signal is described. As shown in Fig. 2 the input signal $x_{in}$ is subject to a Fast Fourier Transform (FFT). Subsequently, the frequency Max(f) of the maximum of the transformed signal is searched for. If $f_{acq}$ represents the frequency estimated by some pre-stage acquisition means (rough estimate for $f_x$) or selected a priori and if the size of the acquisition frequency bin is, e.g., 500 Hz, the search for the peak in the Fourier spectrum is restricted to the interval $[f_{acq} - 500\ Hz, f_{acq} + 500\ Hz]$. The determined frequency that corresponds to the peak represents the first estimate $\hat{f}_{x,0}$ for the frequency $f_x$.

For the i-th iteration of the employed procedure a vector $\mathbf{x}_i$ containing N samples of the input signal and a vector $\mathbf{x}_{L,i}$ containing N samples time-delayed by the integer L with respect to the first samples are to be defined. The respective first vectors read

$$\mathbf{x_1} = (x_{in}(0),\ x_{in}(1),\ ..,\ x_{in}(N\text{-}1))\ \text{and}\ \mathbf{x_{1,L}} = (x_{in}(L),\ x_{in}(L+1),\ ..,\ x_{in}(L+N\text{-}1)).$$

Next, the vectors are subject to a Discrete Time Fourier Transform evaluated in the form

$$X_1(f) = \sum_{n=0}^{N-1} x_{in}(n)\exp(-i2\pi f n)\ \text{ and }\ X_2(f) = \sum_{n=0}^{N-1} x_{in}(n+L)\exp(-i2\pi f n),$$

respectively.

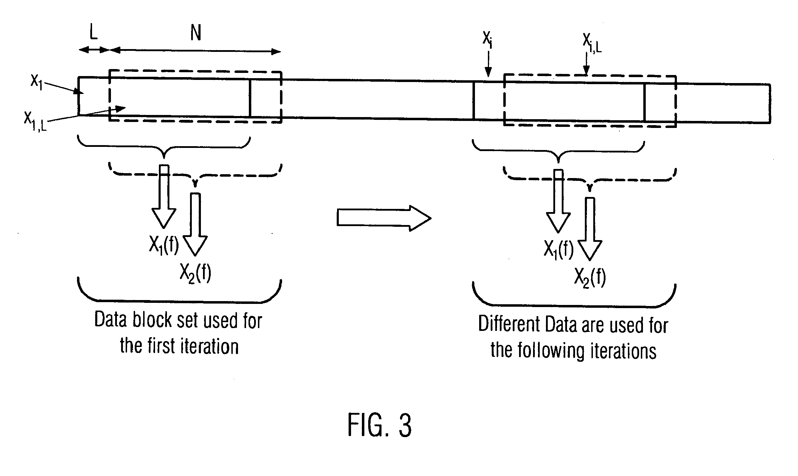

The data blocks used for the first as well as the i-th iteration are illustrated in Fig. 3. The data blocks represented by $\mathbf{x}_1$ and $\mathbf{x}_{1,L}$ overlap each other due to the fact that the time-delay L is lower than N. The same holds for the vectors $\mathbf{x}_i$ and $\mathbf{x}_{i,L}$, used in subsequent iterations. For simplicity, the respective DTFTs are denoted by $X_1$ and $X_2$ for each iteration whereas they are based on different data blocks for each of the iterations.

The ratio of $X_2$ and $X_1$ can be obtained as

$$r(f) := m_r(f)\exp(i\varphi_r(f)) = \frac{a\ \exp(i2\pi f_x L)D(f - f_x) + a\,^*\exp(-i2\pi f_x L)D(f + f_x)}{aD(f - f_x) + a\,^* D(f + f_x)}$$

where $D(f) = \sin(\pi f N) / \sin(\pi f)$ and $a = \exp(i(\varphi + \pi f_x(N - 1)))$ and the asterisk denotes the conjugate complex.

The phase $\varphi_r(f)$ of the ratio r(f) is actually used to estimate $f_x$. One should note that D(0) = N and that D(2 $f_x$) is negligible as compared to D(0) and even equals zero, if $f_x = k / N$, where k is an integer. Furthermore, if $f_x = k / N$, r $(f_x) = m_r(f)\exp(i\varphi_r(f)) = \exp(i2\pi f_x L)$. Consequently, the fixed point mapping

$$g(f_x,\ f_x) = \frac{\varphi_r(f_x)}{2\pi\ L} = f_x$$

holds at least in good approximation. The solution of the fixed point mapping is obtained by the iteration $\hat{f}_{x,i+1} = g(\hat{f}_{x,i}, f_x)$, where the circumflex indicates the estimate of the respective iteration step i. As mentioned above the initial value for the iteration $\hat{f}_{x,o}$ is obtained by means of an FFT of the input signal $x_{in}$. At the i-th iteration the DTFTs of $\mathbf{x}_i$ and $\mathbf{X}_{L,i}$ are evaluated for $f = \hat{f}_{x,i-1}$ ($\hat{f}_{x,i-1}$ being the value of the estimate for $f_x$ at the (i - 1) iteration). Subsequently, the ratio DTFT $(\mathbf{x}_{L,i}) / $ DTFT$(\mathbf{x}_i)$ at $f = \hat{f}_{x,i-1}$ and the phase $\varphi_{r,i}$ (f) are calculated from which the new frequency estimation results as

$$\hat{f}_{x,i} = \frac{\varphi_{r,i}}{2\pi L}.$$

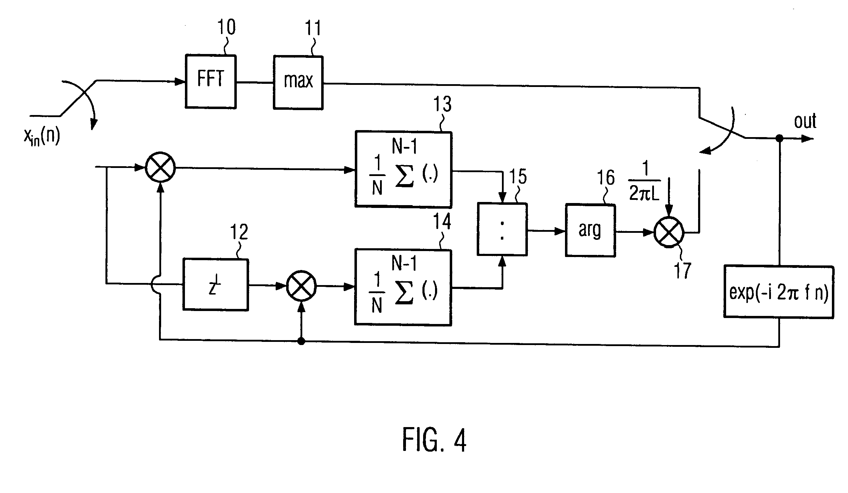

For illustration purposes Fig. 4 shows a flowchart of an example of the disclosed method. The input signal $x_{in}$(n) is subject to an FFT 10 and the frequency of the peak in the Fourier transformed spectrum is determined 11. On the other hand, sample vectors $\mathbf{x}_i$ and $\mathbf{x}_{L,i}$ that is time-delayed 12 by L with respect to $\mathbf{x}_i$ are defined and respectively subject to a DTFT 13 and 14 as described above. The ratio 15 and the phase 16 of the ratio of the DTFTs $X_2$ and $X_1$ are calculated. By means of the phase the above mentioned fixed point mapping is built. At the end of the iteration process the finally estimated frequency is output. The output signal of the thus constituted Frequency Lock Loop can be used, e.g., for tracking of the carrier frequency of a GPS signal.

Due to the elimination of multiples of $2\pi$ the problem of phase ambiguities arises when employing the DTFT. This problem can be solved by adding a correction term to the estimated frequency, in particular, by adding a term round $(\hat{f}_{x,0} L)$ that takes into account the integer number of $2\pi$ - number of cycles. Thus, the output signal can be generated including such a correction term. In addition, depending on the convergence properties of the iteration procedure each iteration estimate may be buffered and sorted and the center value of the estimated frequencies might be chosen for the output signal. Mean values of estimated frequencies taken over different time periods may also be used to generate the output signal.

**Claims**

1. Method for estimating the frequency $(f_x)$ of a periodic input signal $(x_{in})$, comprising

    performing a Discrete Time Fourier Transform of N first time-discrete samples (x) of the input signal $(x_{in})$, N being an integer $\geq 1$, to obtain a first transformed signal $(X_1)$;

    performing a Discrete Time Fourier Transform of N second time-discrete samples $(\mathbf{x}_L)$ of the input signal $(x_{in})$ time-delayed by L samples with respect to the first time-discrete samples (x), L being an integer $\geq 1$, to obtain a second transformed signal $(X_2)$;

    calculating the phase $(\varphi_r)$ of the ratio (r) of the second transformed signal $(X_2(f))$ and the first transformed signal $(X_1(f))$ at one single pre-selected frequency (f);

    determining an estimate $(\hat{f}_x)$ for the frequency $(f_x)$ of the periodic input signal $(x_{in})$ on the basis of the phase $(\varphi_r)$ of the ratio of the second transformed signal $(X_2(f))$ and the first transformed signal $(X_1(f))$ at the pre-selected frequency (f); and

    generating an output signal on the basis of the estimate $(\hat{f}_x)$ for the frequency $(f_x)$.

2. The method according to claim 1, wherein the estimate $(\hat{f}_x)$ for the frequency $(f_x)$ of the periodic input signal $(x_{in})$ is iteratively calculated and the output signal is generated on the basis of the iteratively calculated values for $\hat{f}_x$.

3. The method according to claim 2, wherein the frequency $(f_x)$ of the periodic input signal $(x_{in})$ is estimated by the solution of a fixed point mapping $g(f_x, f_x) = \dfrac{\varphi_r(f_x)}{2\pi L} = f_x$, where $\varphi_r$ denotes the phase of the ratio of the second

    transformed signal $(X_2(f))$ and the first transformed signal $(X_1(f))$ at the pre-selected frequency (f) and the output signal is generated on the basis of the solution of the fixed point mapping.

4. The method according to claim 2 or 3, wherein the frequency $(f_x)$ of the periodic input signal $(x_{in})$ is estimated by a fixed point iteration according to $\hat{f}_{x,i+1} = g(\hat{f}_{x,i}, f_x)$, where $\hat{f}_{x,i}$ denotes the i-th estimate, $i \geq 0$, for the frequency $(f_x)$ of the periodic input signal $(x_{in})$.

5. The method according to one of the claims 2 - 4, wherein the first estimate of the iteration $(\hat{f}_{x,0})$ for estimating the frequency $(f_x)$ of the periodic input signal $(x_{in})$ is calculated by a Fast Fourier Transform.

6. The method according to claim 5, wherein the first estimate of the iteration $(\hat{f}_{x,0})$ for the frequency $(f_x)$ of the periodic input signal $(x_{in})$ is calculated by seeking for the peak of the Fast Fourier Transform in an interval ranging from one acquisition frequency bin below a rough estimate for the frequency $(f_x)$ of the periodic input signal $(x_{in})$ to one acquisition frequency bin above the rough estimate for the frequency $(f_x)$ of the periodic input signal $(x_{in})$.

7. The method according to one of the claims 2 to 6, further comprising comparing the estimated frequency $\hat{f}_x$ as well as $\hat{f}_x - \Delta$ and $\hat{f}_x + \Delta$, where $\Delta$ denotes some frequency leap, with a rough estimate for the frequency $(f_x)$ of the periodic input signal $(x_{in})$ or with the first estimate of the iteration $(\hat{f}_{x,0})$ for the frequency $(f_x)$ of the periodic input signal $(x_{in})$ and generating the output signal on the basis of the comparison result.

8. The method according to one of the claims 2 - 7, wherein for i iterations, $i \geq 2$, i ratios of respective second transformed signals ($X_{L,i}(f)$) obtained by Discrete Time Fourier Transforms of N second time-discrete samples ($\mathbf{x}_{L,i}$) delayed by L samples with respect to N first time-discrete samples ($\mathbf{x}_i$) and respective first transformed signals ($X_i(f)$) obtained by Discrete Time Fourier Transforms of N first time-discrete samples ($\mathbf{x}_i$) for a frequency that is equal to the estimation ($\hat{f}_{x,i-1}$) of the frequency ($f_x$) of the periodic input signal ($x_{in}$) at the (i - 1) - th iteration and i phase values ($\varphi_{r,i}$) for the respective i ratios are calculated, and

an i-th frequency estimation ($\hat{f}_{x,i}$) is calculated by $\hat{f}_{x,i} = \dfrac{\varphi_{r,i}}{2\pi L}$ , which subsequently is used for the i+1-th frequency estimation ($\hat{f}_{x,i+1}$) calculated by $\hat{f}_{x,i+1} = g(\hat{f}_{x,i}, f_x)$.

9. The method according to one of the preceding claims, further adding a correction term to the estimated frequency in order to avoid phase ambiguities.

10. The method according to claim 9, wherein the correction term is given by the rounded integer of $2\pi$- number of cycles to the estimated frequency ($\hat{f}_x$; $\hat{f}_{x,i}$) in order to avoid phase ambiguities.

11. The method according to one of the preceding claims, further filtering the input signal ($x_{in}$) by means of a noise reduction filtering means before performing the Discrete Time Fourier Transform of the N first time-discrete samples ($\mathbf{x}$).

12. The method according to one of the preceding claims, further down-sampling the periodic input signal ($x_{in}$) before performing the Discrete Time Fourier Transform of the N first time-discrete samples ($\mathbf{x}$).

13. The method according to claim 12, further comprising filtering the down-sampled input signal ($x_{in}$) by means of a noise reduction filtering means before performing the Discrete Time Fourier Transform of the N first time-discrete samples ($\mathbf{x}$).

14. The method according to claim 12 or 13, further comprising band-pass anti-aliasing filtering the pre-down-sampling input signal ($x_{in}$).

15. The method according to one of the preceding claims, wherein $N \geq L$.

16. The method according to one of the claims 2 - 15, further comprising sorting a pre-selected number of iteratively calculated estimates ($\hat{f}_{x,i}$) for the frequency ($f_x$) of the periodic input signal ($x_{in}$) and generating the output value on the basis of the center value of the sorted estimates ($\hat{f}_{x,i}$).

17. The method according to one of the preceding claims, further comprising determining a mean value over a pre-selected time period of iteratively calculated estimates ($\hat{f}_{x,i}$) for the frequency ($f_x$) of the periodic input signal ($x_{in}$).

18. The method according to claim 17, further comprising filtering mean values of iteratively calculated estimates ($\hat{f}_{x,i}$) for the frequency ($f_x$) of the periodic input signal ($x_{in}$) by a median filter, wherein the filtering comprises sorting a pre-selected number of mean values taken over pre-selected time periods of iteratively calculated estimates ($\hat{f}_{x,i}$) for the frequency ($f_x$) of the periodic input signal ($x_{in}$) and generating the output value on the basis of the center value of the sorted mean values.

19. The method according to one of the preceding claims, wherein the periodic input signal ($x_{in}$) is obtained from a signal exhibiting a Doppler shifted frequency by substantially correcting for the Doppler shift.

20. The method according to claim 19, wherein the Doppler shift is time-varying.

21. The method according to claim 20, wherein the input signal ($x_{in}$) is based on a signal generated by and received from a GPS satellite and further comprising stripping of the C/A code and/or the P code before performing the Discrete Time Fourier Transform of the N first time-discrete samples ($\mathbf{x}$).

22. A data acquisition apparatus, comprising

receiving means configured to receive a periodic input signal ($x_{in}$);

a central processing unit configured to perform the calculations of the method of one of the preceding claims and to determine an estimate ($\hat{f}_x$) for the frequency ($f_x$) of the periodic input signal ($x_{in}$) on the basis of the phase ($\varphi_r$) of the ratio of a calculated Discrete Time Fourier Transform of N time-discrete samples ($\mathbf{x}_L$) of the input signal ($x_{in}$) time-delayed by L samples with respect to the first time-discrete samples ($\mathbf{x}$), L being an integer $\geq 1$, and a calculated Discrete Time Fourier Transform of first time-discrete samples ($\mathbf{x}$) of the input signal ($x_{in}$), N being an integer $\geq 1$;

output means configured to output an output signal based on the estimate ($\hat{f}_x$) for the frequency ($f_x$) of the periodic input signal ($x_{in}$); and

signal tracking means configured to track the input signal ($x_{in}$) on the basis of the output signal.

23. Apparatus according to claim 22, further comprising

first filtering means configured to reduce noise of a noisy input signal ($x_{in}$);

means configured to down-sample the input signal ($x_{in}$);

second filtering means configured to low-pass filter the down-sampled input signal.

24. Apparatus according to claim 22 or 23, wherein the apparatus comprises a receiver, in particular a Global Positioning System receiver, or a frequency synthesizer for digitally tuned radio receivers and transmitters or a decoder for remote control and telecommunications.

25. Navigation system for a vehicle, comprising an apparatus according to one of the claims 22 - 24.

26. Computer program product, comprising one or more computer readable media having computer-executable instructions for performing the steps of the method according to one of the Claims 1 - 21.

FIG. 1

FIG. 2

FIG. 3

FIG. 4

EP 1 847 837 A1

**European Patent Office**

**EUROPEAN SEARCH REPORT**

Application Number

EP 06 00 8339

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 5 640 431 A (BRUCKERT ET AL) 17 June 1997 (1997-06-17) * column 4, line 22 - column 6, line 15; figures 1,2 * | 1-26 | INV. G01R23/16 |
| | ----- | | |
| A | US 2002/084933 A1 (KRASNER NORMAN F) 4 July 2002 (2002-07-04) * page 6, paragraph 81 - page 7, paragraph 99; figures 11-14 * | 1-26 | |
| | ----- | | |
| A | EP 1 215 824 A (NOKIA CORPORATION) 19 June 2002 (2002-06-19) * page 10, line 10 - line 41; figures 3A-C * | 1-26 | |
| | ----- | | |

TECHNICAL FIELDS
SEARCHED (IPC)

G01R
G01S
H04B

The present search report has been drawn up for all claims

| Place of search | Date of completion of the search | Examiner |
|---|---|---|
| The Hague | 20 September 2006 | Aouichi, Mohamed |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
......................................................................................
& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 06 00 8339

This annex lists the patent family members relating to the patent documents cited in the above-mentioned European search report.
The members are as contained in the European Patent Office EDP file on
The European Patent Office is in no way liable for these particulars which are merely given for the purpose of information.

20-09-2006

| Patent document cited in search report | | Publication date | Patent family member(s) | | Publication date |
|---|---|---|---|---|---|
| US 5640431 | A | 17-06-1997 | CA 2189343 A1<br>FI 964491 A<br>IL 116781 A<br>KR 230029 B1 | | 26-09-1996<br>08-11-1996<br>26-01-1999<br>15-11-1999 |
| US 2002084933 | A1 | 04-07-2002 | NONE | | |
| EP 1215824 | A | 19-06-2002 | US 2002110184 A1 | | 15-08-2002 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5222843 A